# EUROPEAN PATENT APPLICATION

(11) **EP 4 770 318 A1**
(43) Date of publication of application: **01.07.2026**
(21) Application number: 25218455.1
(22) Date of filing: 25.11.2025
(51) Int. Cl.: H10D 30/01, H10D 30/67, H10D 84/01

(54) **TRANSISTOR SOURCE/DRAIN BARRIERS FOR SUBFIN REMOVAL**

(30) Priority: 26.12.2024 US 202419002551
(71) Applicant: Intel Corporation, Santa Clara, CA 95054 (US)
(72) Inventor: FANG, Sheng-Po, Vancouver, 98686 (US); JUN, Hwichan, Portland, 97229 (US); GUHA NEOGI, Tuhin, Sherwood, 97007 (US)
(74) Representative: 2SPL Patentanwälte PartG mbB

(57) **Abstract**

Transistor structures with silicon source and drain semiconductor material that is protected from a backside silicon subfin material removal process by an intervening barrier material layer. A source/drain barrier material layer may comprise a crystalline material, such as SiGe, grown on the subfin prior to growth of the source/drain material. Optionally, a growth mask may be deposited over channel material before growing source/drain barrier material layer to avoid a heterojunction between channel and source/drain semiconductor materials. Alternatively, a source/drain barrier material layer may comprise an amorphous dielectric material deposited on the subfin prior to growth of the source/drain material. Following frontside processing, a workpiece may be inverted and subfin material removed selectively over the source/drain barrier material layer.

## Description

### BACKGROUND

For advanced integrated circuits (ICs), front-side interconnect metallization dimensions continue to scale to smaller dimensions, increasing their electrical resistance. Introducing back-side interconnect metallization, for example to supply transistors power, counters the trend of increasing electrical resistance.

The presence of semiconductor material on the backside of a transistor (e.g., "fin") structure and often referred to as the "subfin," can induce electrical leakage, particularly in the presence of back-side interconnect metallization. Such electrical leakage can be detrimental to IC operation, especially for low power applications.

Transistor architectures that reduce subfin leakage of an IC die are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods of fabricating IC devices including transistor structures protected by source and drain barrier layers, in accordance with some embodiments;
FIG. 2A, 2B, 2C and 2D are cross-sectional views of transistor structures evolving as the methods illustrated in FIG. 1 are practiced, in accordance with some embodiments;
FIG. 3A, 3B, 3C and 3D are cross-sectional views of transistor structures evolving as the methods illustrated in FIG. 1 are practiced, in accordance with some alternative embodiments;
FIG. 4A, 4B, 4C and 4D are cross-sectional views of transistor structures evolving as the methods illustrated in FIG. 1 are practiced, in accordance with some alternative embodiments;
FIG. 5A, 5B and 5C are cross-sectional views of IC die structures further evolving to include front-side and back-side transistor interconnects as the methods illustrated in FIG. 1 are practiced, in accordance with embodiments;
FIG. 6 illustrates a mobile computing platform and a data server machine employing an IC device including transistor structures protected by source and drain barrier layers, in accordance with some embodiments; and
FIG. 7 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. In one example, two compositions that are substantially the same, have only incidental chemical variation. As another example, composition that is substantially a first constituent means the composition may further include <1% of any other constituent. A composition that is substantially first and second constituents means the composition may further include <1% of any constituent substituted for either the first or second constituent.

In accordance with embodiments herein, subfin semiconductor material is removed, for example to reduce electrical leakage of an IC die comprising transistors initially fabricated upon the subfin semiconductor material. Embodiments herein overcome challenges associated with removing the subfin, such as incurring collateral loss or damage to source and/or drain semiconductor material by introducing a liner or barrier material at a base of the source and/or drain semiconductor material. The barrier material, as an intervening layer between subfin material and source and drain material, can protect source and drain material from processes performed to remove subfin semiconductor material even where the source and drain material is compositionally similar to that of the subfin material. For example, in embodiments where both subfin material and source/drain material are silicon, an intervening barrier comprising a material resistant to a silicon etch process may function as an etch stop to protect the source/drain semiconductor material while the subfin is removed by the silicon etch process. As further described below, the source/drain barrier material may be sacrificial or a material that is retained in a final IC die structure.

Depending on the implementation, the source/drain barrier material may be a semiconductor or dielectric material, the barrier material may also be a highly crystalline material or a substantially amorphous material. A barrier material compatible with epitaxial growth of source and drain semiconductor material that is integrated into the fabrication of transistor structures in accordance with embodiments herein may significantly reduce subfin leakage. Furthermore, a bottom parasitic transistor structure, which is reliant on the subfin semiconductor material, can be eliminated from IC die structures, thereby reducing a bottom parasitic capacitance between the transistor gate electrode and source drain semiconductor material.

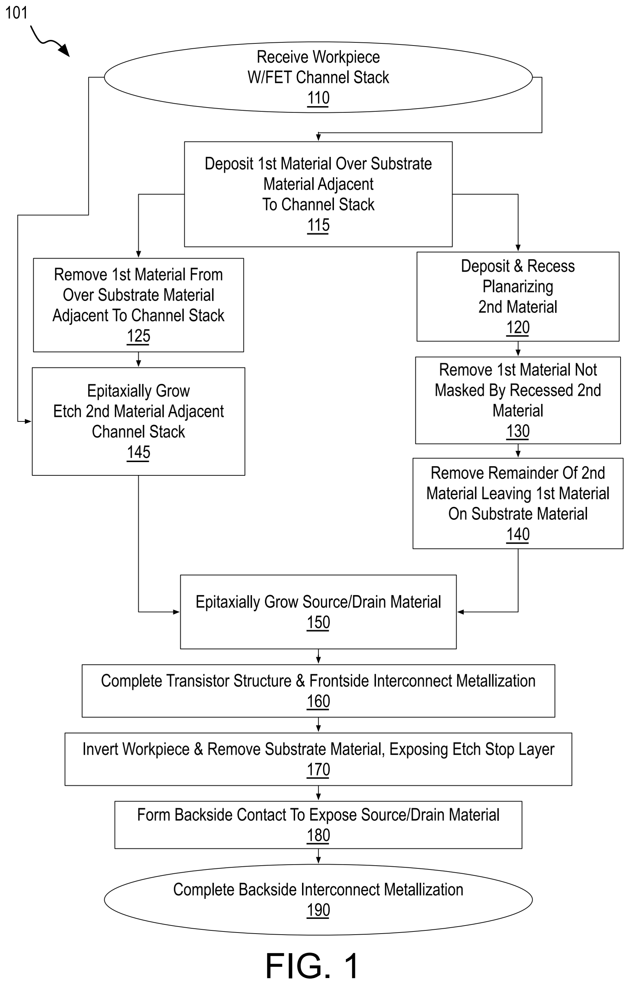

FIG. 1 is a flow diagram illustrating methods 101 for fabricating a transistor structure with source and drain semiconductor structures protected by a bottom barrier material, in accordance with some exemplary embodiments. Methods 101 begin at input 110 with receipt of a workpiece including field effect transistor (FET) structures comprising one or more channel semiconductor material layers within a channel stack. In some examples, the workpiece received at input 110 comprises a 300-450 mm diameter wafer. The workpiece may include a substantially monocrystalline subfin material and any number of transistor channel material layers over the subfin material. Depending on the IC manufacturing process, various other transistor features may also be present on the workpiece. For example, a gate electrode may be present, various isolation dielectric materials may be present, etc. However, at input 110 source/drain semiconductor material has not yet been formed for at least a subset of transistor structures that will have source/drain semiconductor material that benefit from having a bottom barrier material present during a subsequent removal of the subfin material.

Following input 110, methods 101 continue either at block 115 or at block 145. For embodiments where block 115 is practiced, a first material is deposited over regions of the subfin material adjacent to the channel stack. Generally, the first material is non-selectively deposited and is therefore formed over the channel material stack as well as over adjacent regions of the subfin material. In some embodiments, the first material deposited at block 115 is to function as a mask that is selectively removed from the subfin material at block 125 and will then limit to the subfin material a subsequent epitaxial growth of a second material at block 145. The second material epitaxially grown upon the subfin material at block 145 may then function as an etch stop barrier during subsequent removal of the subfin material. In some alternative embodiments further illustrated in FIG. 1, the first material deposited at block 115 is to function as the etch stop barrier during subsequent removal of the subfin material following the deposition and recess of a planarized second material at block 120 so that a portion of the first material not protected by the masking second material is selectively removed at block 130 from surfaces other than those of the subfin material, such as surfaces of the channel stack where retaining an etch stop barrier may be detrimental. The planarizing first material is then removed at block 140.

In alternative embodiments where methods 101 proceed from input 110 directly to block 145, an epitaxial growth process forms a first material that is to function as an etch stop barrier during subsequent removal of the subfin material. In contrast to embodiments where a growth mask material is first patterned, the epitaxial growth process performed at block 145 may also form epitaxial etch stop material on regions other than the subfin material, such as the channel material. Hence, while these alternative embodiments may have the advantage of simplified fabrication, the formation of epitaxial etch stop material on the channel material surface may impact transistor operation, for example depending on the composition of the material grown at block 145. Accordingly, one or more of the exemplary embodiments illustrated by FIG. 1 may be favored over another depending on other attributes and sensitivities of a particular transistor structure and/or integrated circuit application.

Exemplary embodiments of methods 101 converge at block 150 where source/drain semiconductor material is epitaxially grown. The source/drain semiconductor material may seed from channel semiconductor material, for example. For embodiments where the subfin material has been covered by an epitaxial barrier material at block 145, the source/drain semiconductor material may further seed upon that epitaxial barrier material. For other embodiments where the subfin material has been covered by a non-crystalline barrier material, source/drain semiconductor material may grow laterally from the channel material to extend over the barrier material.

With transistor source/drain semiconductor formed, methods 101 continue at block 160 where the transistor structure(s) are completed, for example with fabrication of a gate stack, contact metallization, etc. A frontside transistor interconnect metallization structure comprising any number of metallization levels embedded in dielectric material may then be fabricated over a first side of the transistor structures according to any known techniques, such as any damascene and/or subtractive patterning processes.

Continuing at block 170, the workpiece is inverted and substrate material is removed from a backside of the transistor structures. The substrate material may be thinned with planarization/grinding processes and then further removed with a chemical etch process selective to the composition of the substrate until the subfin material is removed. The barrier material earlier formed between the subfin and the source/drain material may therefore be exposed at block 170, protecting the source/drain material from the subfin etch process.

At block 180, a backside contact metallization structure may be formed in contact with transistor source/drain material. The backside contact metallization structure may extend through an intervening barrier material, or the barrier material may be stripped off prior to forming backside contact metallization structure. Methods 101 may then be completed with the completion of backside transistor interconnect metallization structure at output 190. A backside transistor interconnect metallization structure may similarly comprise any number of metallization levels embedded in dielectric material over a second side of the transistor structures and may be fabricated according to any known techniques, such as any damascene and/or subtractive patterning processes.

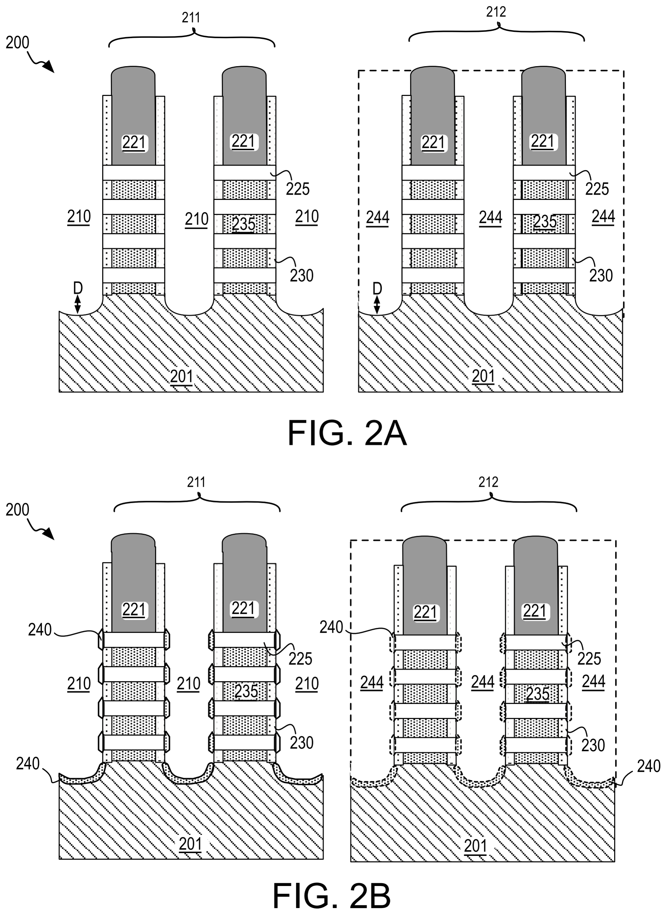

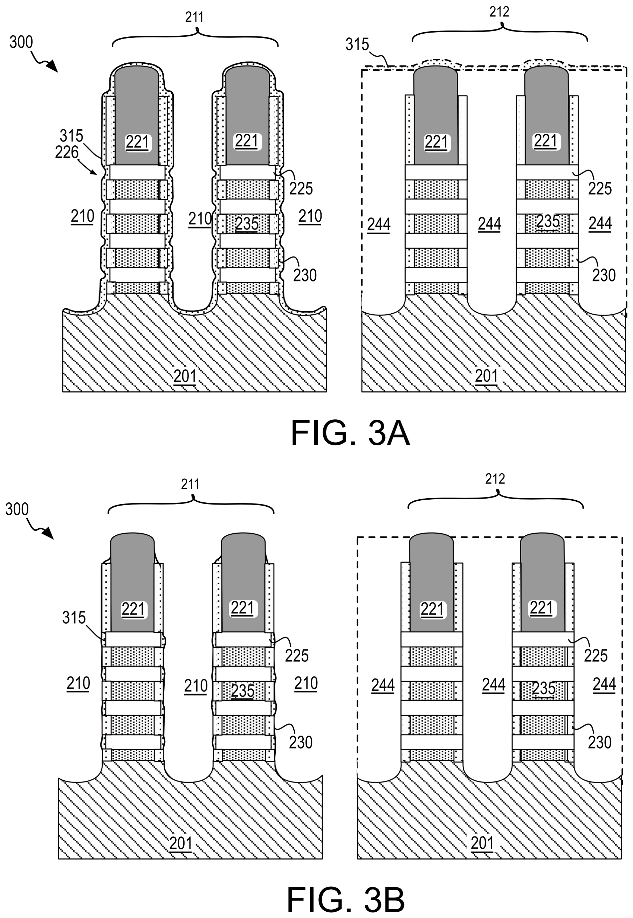

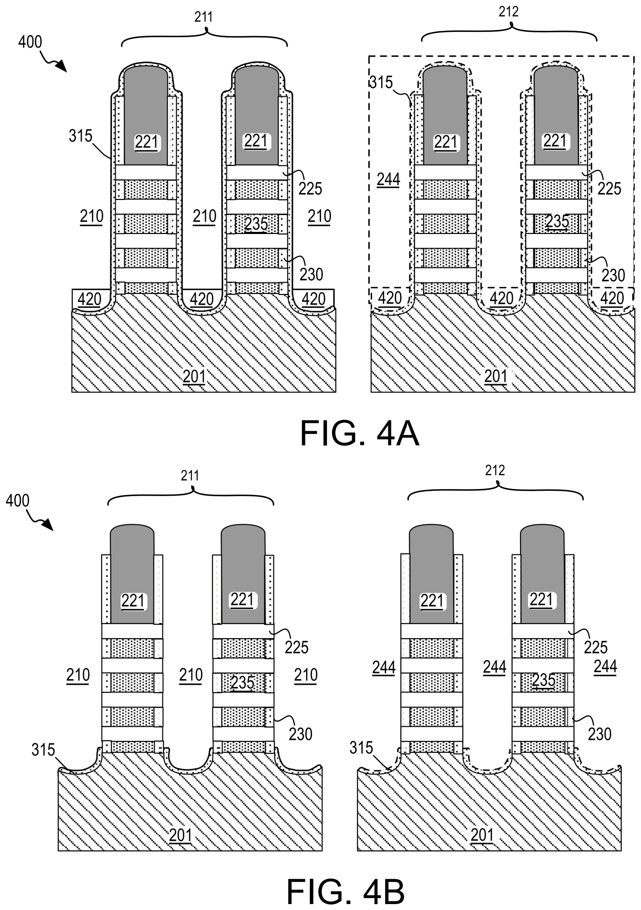

FIG. 2A- 2D are cross-sectional views of transistor structures 200 evolving as methods 101 are practiced in accordance with some embodiments where an etch stop barrier comprising semiconductor material is epitaxially grown without first forming a growth mask. FIG. 3A-3D are cross-sectional views of transistor structures evolving as methods 101 are practiced in accordance with some alternative embodiments where an etch stop barrier comprising semiconductor material is epitaxially grown after first forming a growth mask. FIG. 4A-4D are cross-sectional views of transistor structures evolving as methods 101 are practiced in accordance with some alternative embodiments where an etch stop barrier comprising a dielectric material is formed. The transistor structures depicted in FIG. 2A-4D further highlight structural features associated with particular embodiments of methods 101. However, the practice of methods 101 need not result in all the structures exactly as illustrated in FIG. 2A-4D. Other implementations of methods 101 are also possible, and not all aspects of methods 101 need be practiced by all implementations of the various embodiments illustrated in FIG. 1.

In the example illustrated in FIG. 2A, transistor structures 200 comprise a first plurality of transistor channel material stacks 211 and an adjacent second plurality of transistor channel material stacks 212. Transistor channel material stacks 211 are associated with a first subset of transistor structures, such as ones of a first conductivity type while transistor channel material stacks 212 are associated with a second subset of transistor structures, such as ones of a second conductivity type. In some exemplary embodiments, transistor channel material stacks 211 are associated with N-type (NMOS) transistor structures while transistor channel material stacks 212 are associated with P-type (PMOS) transistor structures.

Within each of transistor channel material stacks 211, there is a plurality of bilayers. Each bilayer may comprise a channel material 225 and a sacrificial material 235. The number of bilayers may vary with implementation. Channel material 225 may have any composition suitable for a channel of a field effect transistor (FET). In some examples, channel material 225 is substantially pure silicon. In other embodiments, channel material 225 comprises germanium (e.g., SiₓGe₁₋ₓ, GeₓSn₁₋ₓ, or substantially pure Ge). In some embodiments, channel material 225 includes a transition metal and a chalcogen. The transition metal may be any transition metal such as any element of groups 4 through 11, the group 3 elements scandium and yttrium, and the inner transition metals (e.g., f-block lanthanide and actinide series). Notable transition metals are molybdenum and tungsten. The chalcogen may be sulfur, selenium, and tellurium. In still other embodiments, channel material 225 comprises one or more metals and oxygen (i.e., metal oxide semiconductor), such as, but not limited to, Indium, gallium zinc oxide (IGZO).

Regardless of chemical composition, channel material 225 is advantageously crystalline. Although the crystalline semiconductor includes polycrystalline thin film material, in some embodiments channel material 225 is substantially monocrystalline. In some examples where channel material 225 is substantially pure silicon, the crystallinity of channel material 225 is cubic with a top surface having a crystallographic orientation of (100), (111), or (110). However, other crystallographic orientations are also possible. In other examples, channel material 225 may be polycrystalline or amorphous, for example in certain metal chalcogen and/or metal oxide embodiments.

Sacrificial material 235 has a different composition than channel material 225. In some examples, sacrificial material 235 has more germanium than channel material 225. For example, where channel material 225 is predominantly silicon, sacrificial material 235 is Si₁₋ₓGex, with X advantageously between 0.3-0.35. In other embodiments, sacrificial material 235 has less germanium than channel material 225. For example, where the channel material 225 is Si₁₋ₓGex, sacrificial material 235 may be predominantly silicon. In other embodiments where channel material 225 is a first metal chalcogenide, sacrificial material 235 may be a second metal chalcogenide or a metal oxide, for example.

Transistor channel material stacks 212 likewise comprise a plurality of bilayers, each of which comprises channel material 225 and sacrificial material 235. The composition of channel material 225 and sacrificial material 235 of channel material stack 212 may each be the same or differ from those of transistor channel material stacks 211. In some embodiments where compositions differ, the composition of channel material 225 and sacrificial material 235 within transistor channel material stacks 212 may be complementary to those of transistor channel material stacks 211. For example, where channel material 225 of channel material stack 211 is substantially pure silicon and sacrificial material 235 is Si₁₋ₓGex, channel material 225 of channel material stack 212 is Si₁₋ₓGex and sacrificial material 235 is pure silicon. In other embodiments, channel material 225 of both channel material stacks 211 and 212 are pure silicon while sacrificial material 235 of both channel material stacks 211 and 212 are Si₁₋ₓGex.

In some embodiments, a source/drain bottom barrier is formed only on a subset of transistor structures, for example a subset of transistor structures that are to have a source/drain semiconductor material that is compositionally similar to the composition of subfin semiconductor. In alternative embodiments, a source/drain bottom barrier is formed on all transistor structures, for example both within transistor structures that are to have a source/drain semiconductor material that is compositionally similar to the composition of subfin semiconductor and within transistor structures that are to have a source/drain semiconductor material that is compositionally distinct from the composition of subfin semiconductor. Formation of a barrier layer even for transistor structures even where there is compositional differentiation between source/drain semiconductor and the subfin semiconductor may advantageously simplify the fabrication process as there is then no need to pattern barrier material separately, for example between NMOS and PMOS transistor structures. Also, source and drain semiconductor material structures may then have substantially the same depth or height, potentially simplifying backside contact/via metallization.

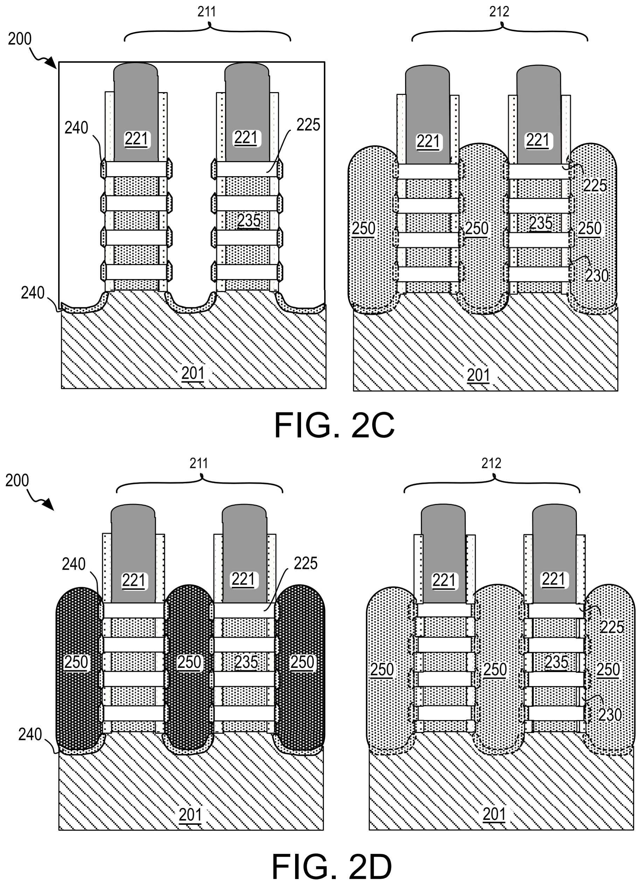

As illustrated in FIG. 2A, transistor channel material stacks 212 may be optionally covered with a dielectric material 244, which is shown in dashed line to illustrate embodiments where source/drain semiconductor barrier material is only to be formed on a subset of transistor structures. For alternative embodiments, dielectric material 244 may be omitted such that the treatments illustrated for channel material stacks 211 are applicable to channel material stacks 212. Dielectric material 244 may have any composition known to be suitable as a hardmask for selectively processing channel material stacks 211. In some examples, dielectric material 244 is silicon oxide (SiO), silicon nitride (SiN), or silicon oxynitride, (SiON). Although only one layer is illustrated in FIG. 2, dielectric material 244 may comprise one or more material layers having a total thickness, for example in the range of 20-60 nm.

As further illustrated in FIG. 2A, transistor channel material stacks 211 (and 212) are over a subfin material 201 with a portion of subfin material 201 adjacent to the channel material stacks exposed at a bottom of spaces 210. In exemplary embodiments, subfin material 201 is a portion a (mono)crystalline substrate material. For example, subfin material 201 may be substantially monocrystalline silicon (e.g., with only trace impurities and/or crystal defects). As shown, a top surface of subfin semiconductor material 201 within space 210 may be recessed a depth D relative to the portion of subfin semiconductor material 201 directly below channel material stacks 211.

Channel material stacks 211 (and 212) include a sidewall spacer dielectric material 230 protecting underlying channel material. Sidewall spacer dielectric material 230 may comprise a silicon-based dielectric (e.g., SiO₂, Si₃N₄, SiON, etc.). Optionally, adjacent layers of channel material 225 may be recess etched, for example with an isotropic etch process selective to the channel semiconductor material, to form a dimple (not depicted) that may then be backfilled with an additional sidewall spacer dielectric material. Transistor channel material stacks 211 (and 212) further include one or more hardmask materials 221, which may be, for example, a silicon-based dielectric such as SiO₂, Si₃N₄, SiON, etc.

As further shown in FIG. 2B, a barrier material 240 is epitaxially grown on crystalline seed surfaces. Barrier material 240 forms on portions of subfin material 201 adjacent to channel material stacks 211. In the illustrated embodiment, no barrier material is formed on channel material stacks 212 since potential seeding surfaces are protected by dielectric material 244. However, in the absence of any mask material over channel material stacks 211, barrier material 240 may also grow on exposed surfaces of channel material 225. For alternative embodiments where dielectric material 244 is omitted, barrier material 240 will be similarly formed on portions of subfin material 201 adjacent to channel material stacks 212.

Barrier material 240 may be any semiconductor material of different chemical composition than subfin material 201. For exemplary embodiments where subfin material 201 is crystalline silicon, barrier material 240 is a crystalline layer of material having a lower silicon content than subfin material. In some examples where subfin material 201 is crystalline silicon, barrier material 240 is a Si₁₋ₓGex alloy where Ge content may be any amount that will subsequently provide a basis for etch selectivity between subfin material 201 and barrier material 240. In some examples, x is at least 5% and may be 30%, or more. In other examples where subfin material 201 is crystalline silicon, barrier material 240 may be pure Ge or a SnGe alloy. Barrier material 240 may be grown to any thickness that will ensure barrier material 240 functions as an adequate etch stop during subsequent removal of subfin material 201. In some examples, barrier material 240 has a layer thickness of 5-10nm.

In FIG. 2C, transistor structures 200 now include source and drain semiconductor material 250. PMOS and NMOS source and drain semiconductor material 250 may be seperately grown. In the illustrated example, while channel material stacks 211 are protected by a dielectric material 244, source and drain semiconductor material 250 are deposited or epitaxially grown adjacent to channel material stack 212. In some exemplary embodiments where channel material stack 212 is associated with a PMOS FET structure, PMOS source and drain semiconductor material 250 is a Si₁₋ₓGex alloy further including acceptor impurities imparting p-type electrical conductivity. In some further embodiments, source and drain semiconductor material 250 has substantially the same composition as barrier material 240 (e.g., both Si₁₋ₓGeₓ).

As further illustrated in FIG. 2D, source and drain semiconductor material 250 may be similarly deposited or epitaxially grown within spaces 210 adjacent to channel material stack 211, for example in direct contact with barrier material 240. Source and drain semiconductor material 250 may comprise any semiconductor material having a high concentration of impurities that impart a particular conductivity. In some exemplary embodiments where channel material stack 211 is associated with an NMOS FET structure, source and drain semiconductor material 250 is substantially pure silicon (i.e., only Group IV element is silicon) further including donor impurities imparting n-type electrical conductivity. Accordingly, except for the greater impurity concentration, source and drain semiconductor material 250 has substantially the same chemical composition as subfin semiconductor material 201 with the intervening barrier material 240 forming a semiconductor heterojunction therebetween.

In some alternative embodiments further illustrated in FIG. 3A-3D, a growth mask may be formed prior to growing barrier material 240 so that growth of barrier material 240 does not form a heterojunction between channel material 225 and source and drain semiconductor material 250.

Referring first to FIG. 3A, transistor structures 300 include the same elements and attributes as described above for transistor structures 200 in the context of FIG. 2A. Accordingly, a liner material 315 may be deposited upon transistor structures 200 to arrive at transistor structures 300. In this example, channel semiconductor material layer 225 has received a dimple etch, which laterally recesses channel semiconductor material layer 225 relative to sidewall spacer dielectric 230, forming a dimple 226. In this example, channel material stacks 212 may again be optionally protected by dielectric material 244, which is therefore again illustrated in dashed line. However, in alternative embodiments where dielectric material 244 is omitted, liner material 315 may instead be deposited on the underlying channel material stacks 212 substantially as illustrated for channel material stacks 211.

Liner material 315 may have any chemical composition and may be deposited with any deposition process suitable for the composition and offering adequate thickness conformality, such as chemical vapor deposition (CVD) or atomic layer deposition (ALD). In some examples, liner material 315 is a dielectric material and may be a silicon-based dielectric, such as such as SiO₂, Si₃N₄, SiON, SiOCH, etc. In some further embodiments, liner material 315 has a composition distinct from that of sidewall spacer dielectric 230. Liner material 315 may have any layer thickness that is sufficient to function as an epitaxial growth mask. In some examples, liner material 315 has a layer thickness of 1-10nm.

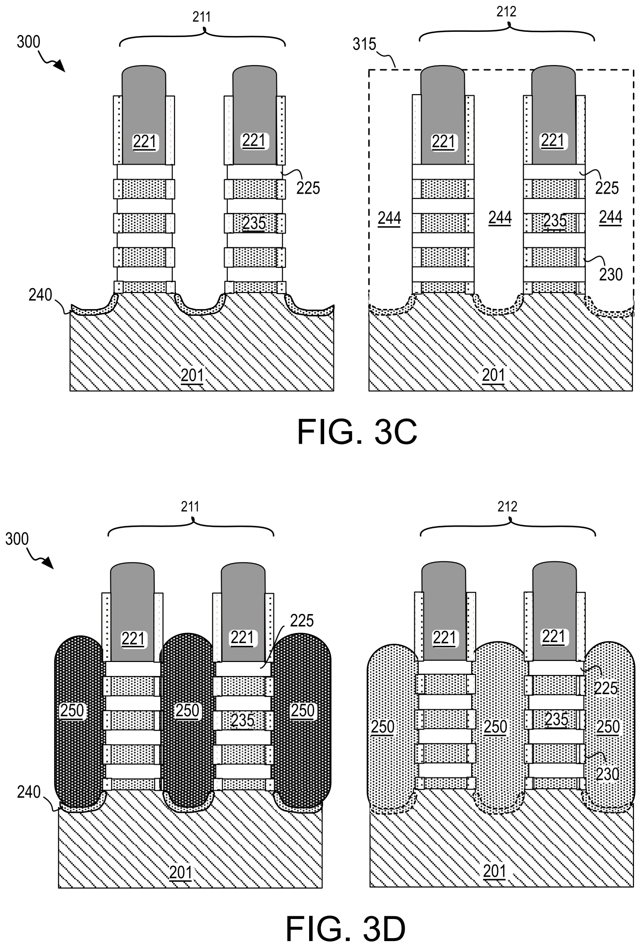

In FIG. 3B, liner material 315 has been selectively removed, for example with a maskless anisotropic etch process (i.e. a spacer blanket etch process) to expose subfin semiconductor material 201 without exposing channel semiconductor material 225. Any etch process suitable for the composition of liner material 315 may be practiced to expose subfin semiconductor material 201. The presence of liner material 315 prevents channel semiconductor material 225 from seeding epitaxial growth of barrier material 240. Growth of barrier material 240 may be therefore confined to the exposed surface of subfin semiconductor material 201. Subsequent to the growth of barrier material 240, liner material 315 may be stripped as a sacrificial material to arrive at structures as depicted in FIG. 3C. In some examples, channel material stacks 212 remain protected by dielectric material 244. However, as illustrated in dashed line, for alternative embodiments where dielectric material 244 is omitted, barrier material 240 may be similarly grown on subfin semiconductor material 201 that is between channel material stacks 212.

As further illustrated in FIG. 3D, source and drain semiconductor material 250 may be deposited or epitaxially grown within spaces 210 adjacent to channel material stacks 211. In absence of any barrier material growth upon channel material 225, source and drain semiconductor material 250 is in direct contact with opposite ends of transistor channel material 225 within stacks 211. In some exemplary embodiments where channel material stacks 211 is associated with an NMOS FET structure, source and drain semiconductor material 250 is substantially pure silicon (i.e., only Group IV element is silicon) further including donor impurities imparting n-type electrical conductivity. FIG. 3D also depicts source and drain semiconductor material 250 deposited or epitaxially grown adjacent to channel material stacks 212. In some exemplary embodiments where channel material stacks 212 are associated with an PMOS FET structures, this source and drain semiconductor material is a Si₁₋ₓGex alloy further including acceptor impurities imparting p-type electrical conductivity and is formed separately from (e.g., after) source and drain semiconductor material for NMOS FET structures.

Although the examples illustrated in FIG. 2A-3D depict a crystalline source/drain barrier material, amorphous barrier material embodiments are also possible. FIG. 4A-4D, for example, further illustrate embodiments where liner material 315 is retained over, rather than removed from, subfin semiconductor material 201. Liner material 315 is then to function as an etch stop barrier that protects source drain semiconductor material during subsequent removal of subfin semiconductor material 201.

As shown in FIG. 4A, liner material 315 has been deposited over channel material stacks 211. Channel material stacks 212 may optionally be differentiated from channel material stacks 211, for example with a mask of dielectric material 244. As illustrated in dashed line, in absence of dielectric material 244, liner material 315 may also been deposited over channel material stacks 212. Liner material 315 may again be of any suitable dielectric material composition, such as a silicon-based dielectric like SiO₂, Si₃N₄, SiON, SiOCH, etc. For the illustrated example, channel semiconductor material 225 has not been recessed with a dimple etch prior to deposition of liner material 315. As further illustrated in FIG. 4A, a planarized mask material 420 has been deposited over liner material 315. In contrast to the highly conformal liner material, mask material 420 is highly non-conformal, and advantageously fills topography bottom-up and/or is flowable. In some examples mask material 420 is an organic polymer applied with a spin coat, spray coat, or similar wet process. Optionally, a top surface of mask material 420 may be planarized following deposition, for example with a chemical mechanical planarization (CMP) process. A top surface of the planarized mask material 420 is then recess etched, for example with a plasma etch process selective to mask material 420, to remain over only a bottom portion of liner material 315.

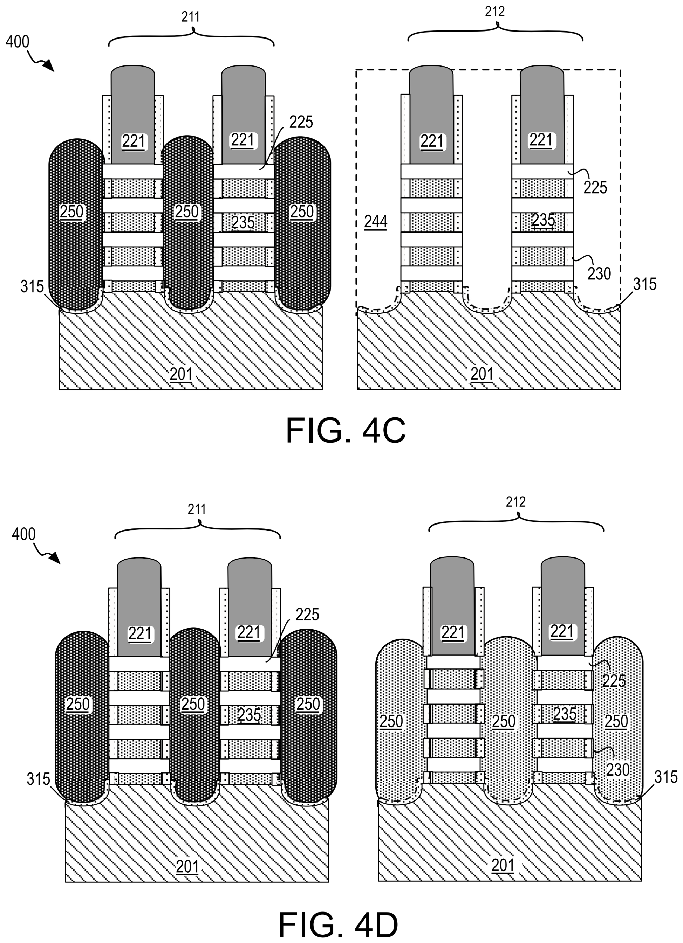

In FIG. 4B, liner material 315 unprotected by mask material 420 has been removed, for example with a selective dry or wet etch process. Remnant mask material 420 may then be similarly stripped to leave only a portion of liner material 315 in contact with subfin semiconductor material 201 adjacent to channel material stacks 211 (i.e., at the bottom of spaces 210). As further illustrated in FIG. 4C, source and drain semiconductor material 250 is epitaxially grown from seeding surfaces of channel semiconductor material 225 and laterally overgrows liner material 315.

As described for other embodiments above, in absence of any barrier material growth upon channel material 225, source and drain semiconductor material 250 is in direct contact with opposite ends of transistor channel material 225 within stacks 211. In some exemplary embodiments where channel material stacks 211 is associated with an NMOS FET structure, source and drain semiconductor material 250 is substantially pure silicon (i.e., only Group IV element is silicon) further including donor impurities imparting n-type electrical conductivity. As illustrated in FIG. 4D, source and drain semiconductor material 250 is also deposited or epitaxially grown adjacent to channel material stacks 212. In some exemplary embodiments where channel material stacks 212 are associated with an PMOS FET structures, this source and drain semiconductor material is a Si₁₋ₓGex alloy further including acceptor impurities imparting p-type electrical conductivity and is formed separately from (e.g., after) source and drain semiconductor material for NMOS transistor structures.

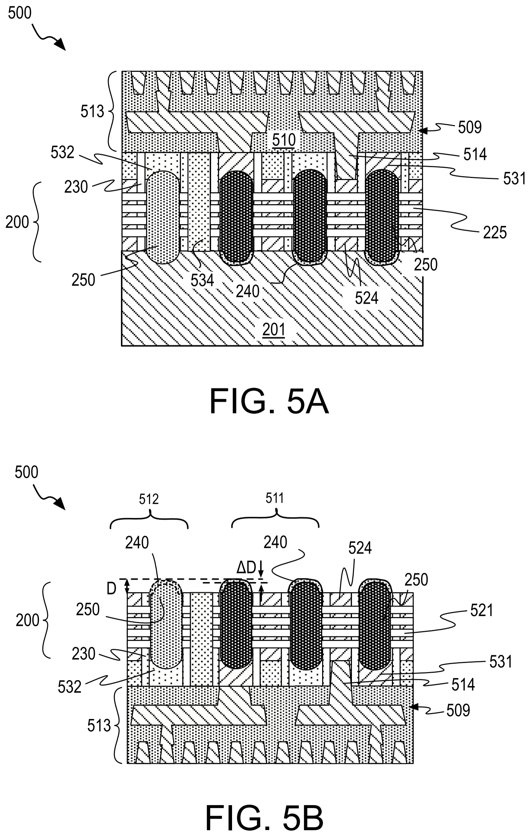

As noted above, following transistor source and drain semiconductor formation transistor structure fabrication may continue, for example with the formation of a gate stack. Transistor source and drain semiconductor may also be contacted with metallization during frontside fabrication. FIG. 5A-5C are cross-sectional views of IC die structures 500 further evolving to include front-side and back-side transistor interconnect metallization structures, for example as the methods 101 (FIG. 1) are practiced subsequent to forming any of the transistor structures 200 (FIG. 2D), 300 (FIG. 3D) or 400 (FIG. 4D).

In FIG. 5A, IC die structure 500 includes frontside transistor interconnect metallization structure 513, which further includes one or more interconnect metallization levels 509 embedded in dielectric material 510. Interconnect metallization levels 509 are interconnected to transistor structures 200. In the illustrated example, a frontside metallization feature 514 is in direct contact with gate electrode 524. Other frontside metallization features may similarly be electrically coupled to a source/drain contact metallization 531, a source/drain contact metallization 532, etc..

In FIG. 5B, IC die structure 500 has been inverted for backside processing that includes removal of subfin semiconductor material 201. In exemplary embodiments where subfin semiconductor material 201 is silicon, removal of the subfin material may include a silicon selective chemical etch. In the illustrated example where subfin semiconductor material 201 was recessed from the frontside prior to source/drain formation, selectivity of the subfin etch relative to source drain material that is of a different composition or relative to barrier material 240 (or liner material 315) that is also of a different composition ensures source and drain semiconductor material 250 stands proud of an adjacent portion of the backside surface by approximately depth D.

For embodiments where barrier material 240 (or a similarly located liner material 315) is retained as a permanent feature of IC die structure 500, a backside surface of barrier material 240 (or liner material 315) may be substantially coplanar with that of a source/drain semiconductor material of a PMOS transistor structure at approximately depth D above a backside surface of gate electrode 524. For alternative embodiments where barrier material 240 (or a similarly located liner material 315) is removed following removal of subfin semiconductor material 201, the backside surface of the source/drain regions for PMOS transistor structure 512 may be a depth D above a backside surface of gate electrode 524 while NMOS transistor structure 511 is a depth D-ΔD above a backside surface of gate electrode 524. The depth ΔD is indicative of a thickness of barrier material 240 or liner material 315 that functioned as an etch stop during subfin removal. In still other embodiments where barrier material 240 (or liner material 315) is formed on bother PMOS and NMOS devices, the backside surfaces of either the source/drain semiconductor material or the barrier/liner material for each will be substantially coplanar (e.g., within 5nm of each other). In contrast, if not for barrier material 240, silicon source and drain semiconductor material of either or both of PMOS and NMOS devices would be removed along with subfin semiconductor material 201, for example becoming coplanar (e.g., within 5nm of each other) with, or recessed below (e.g., by more than 5nm), the backside surface of gate electrode 524.

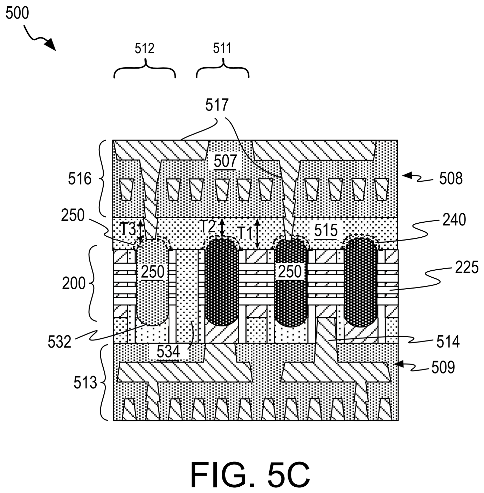

In FIG. 5C, IC die structure 500 has evolved to further include a planarized backside dielectric material layer 612, which is in direct contact with a backside surface of source/drain semiconductor material 250 and/or barrier material 240. In the absence subfin material, backside dielectric material layer 612 is also in direct contact with gate electrode 524 and transistor isolation dielectric 534. With a subfin material removal process that is selective to source/drain semiconductor material 250 and selective to barrier material 240, these materials are non-coplanar with gate electrode 524. The layer thickness of planarized backside dielectric material layer 612 therefore varies from a greatest thickness T1 over gate electrode 524 to lesser thicknesses T2 and/or T3 over NMOS and PMOS source/drain semiconductor material 250, respectively. For embodiments where barrier material 240 is applied only to NMOS transistor structures, thicknesses T2 and T3 may vary by approximately the thickness of barrier material 240 (which may be removed or retained in die structure 500). For embodiments where barrier material 240 is applied to both NMOS and PMOS transistor structures, thicknesses T2 and T3 may be approximately equal and either include the thickness of barrier material 240, or not (if stripped off). In FIG. 5C, dashed line is to emphasize fabrication and retention of barrier material 240 in each of NMOS and PMOS transistor structures is optional.

IC die structure 500 further includes backside transistor interconnect metallization 613 over dielectric material layer 515. Interconnect metallization structure 516 further includes one or more interconnect metallization levels 508 embedded in dielectric material 507. Interconnect metallization levels 508 are interconnected to transistor structures 200, and more specifically to one or more of a gate electrode 524, a source/drain contact metallization 531, or a source/drain contact metallization 532. In the illustrated example, backside interconnect metallization 516 includes a metallization feature 517 is electrically coupled with source semiconductor 250 of both PMOS transistor structure 512 and NMOS transistor structure 511.

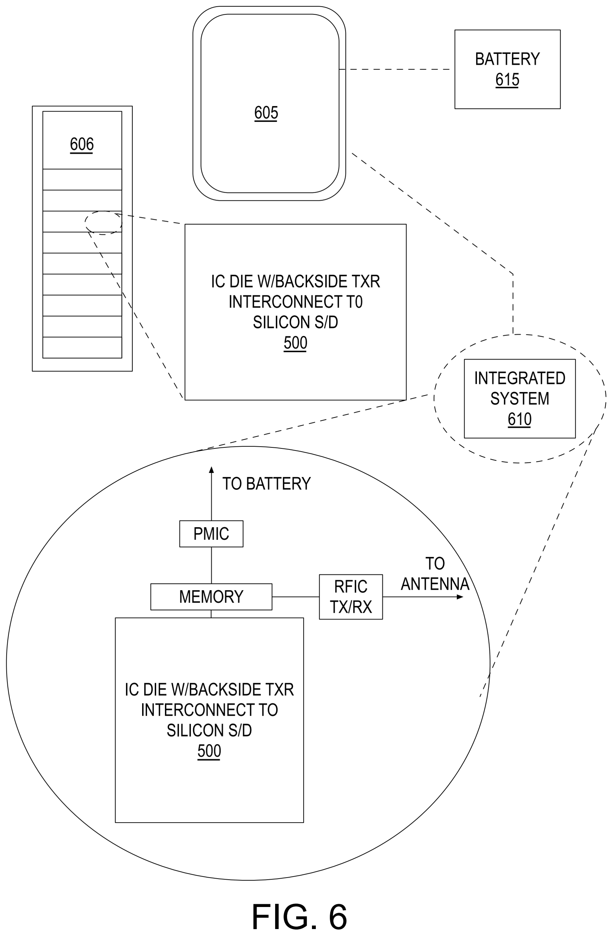

The transistor structures and IC die structures described above may be employed in a wide range of IC devices and further integrated in a wide range of computer-based applications. FIG. 6 illustrates a mobile computing platform 605 and a server machine 606, each employing IC die structure 500 including transistors with silicon source/drain semiconductor material that has been protected with an etch stop during silicon subfin removal and contacted by backside metallization, for example as described elsewhere herein.

Server machine 606 may be any commercial server, for example including any number of high-performance computing platforms disposed within a rack and networked together for electronic data processing, which in the exemplary embodiment includes IC die structure 500 comprising transistors with silicon source/drain semiconductor material that has been protected with an etch stop during silicon subfin removal and contacted by backside metallization, for example as described elsewhere herein. The mobile computing platform 605 may be any portable device configured for each of electronic data display, electronic data processing, wireless electronic data transmission, or the like. For example, the mobile computing platform 605 may be any of a tablet, a smart phone, laptop computer, etc., and may include a display screen (e.g., a capacitive, inductive, resistive, or optical touchscreen), an integrated system 610, and a battery 615.

As illustrated in the expanded view of FIG. 6, one or more of a power management integrated circuit (PMIC) or RF (wireless) integrated circuit (RFIC) including a wideband RF (wireless) transmitter and/or receiver may be further coupled to IC die structure 500. A PMIC may perform battery power regulation, DC-to-DC conversion, etc., and so has an input coupled to battery 615 and an output providing a current supply to other functional modules. An RFIC may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G and beyond.

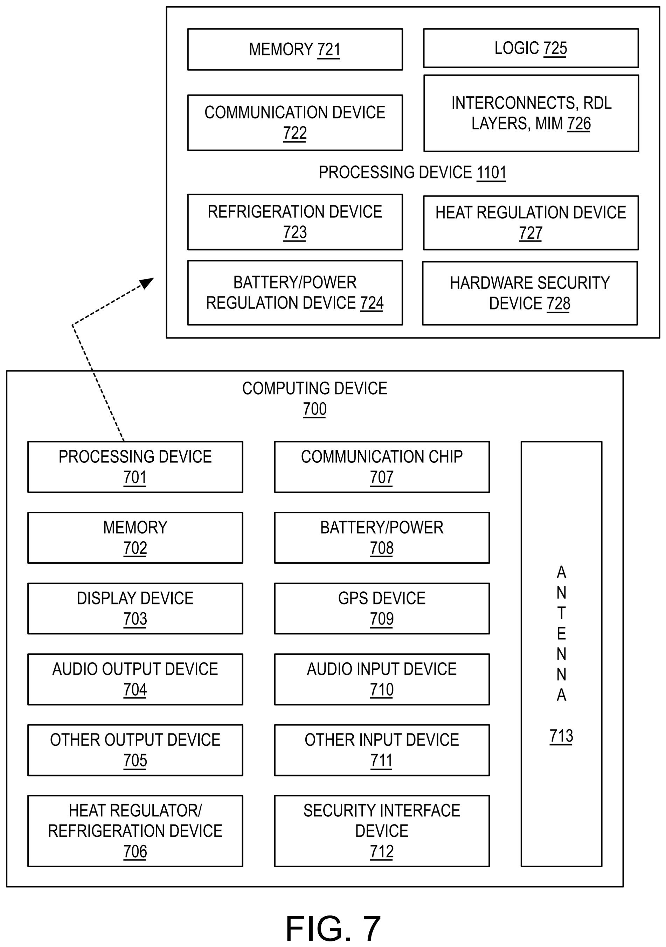

FIG. 7 is a block diagram of a cryogenically cooled computing device 700 in accordance with some embodiments. For example, one or more components of computing device 700 may include transistors with silicon source/drain semiconductor material that has been protected with an etch stop during silicon subfin removal and contacted with backside metallization, for example as described elsewhere herein. A number of components are illustrated in FIG. 13 as included in computing device 700, but any one or more of these components may be omitted or duplicated, as suitable for the application. In some embodiments, some or all of the components included in computing device 700 may be attached to one or more printed circuit boards (e.g., a motherboard). In some embodiments, various ones of these components may be fabricated onto a single system-on-a-chip (SoC) die. Additionally, in various embodiments, computing device 700 may not include one or more of the components illustrated in FIG. 7, but computing device 700 may include interface circuitry for coupling to the one or more components. For example, computing device 700 may not include a display device 703, but may include display device interface circuitry (e.g., a connector and driver circuitry) to which display device 703 may be coupled.

Computing device 700 may include a processing device 701 (e.g., one or more processing devices). As used herein, the term processing device or processor indicates a device that processes electronic data from registers and/or memory to transform that electronic data into other electronic data that may be stored in registers and/or memory. Processing device 701 may include a memory 721, a communication device 722, a refrigeration/active cooling device 723, a battery/power regulation device 724, logic 725, interconnects 726 (i.e., optionally including redistribution layers (RDL) or metal-insulator-metal (MIM) devices), a heat regulation device 727, and a hardware security device 728.

Processing device 701 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 701 may include a memory 702, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 721 includes memory that shares a die with processing device 701. This memory may be used as cache memory and may include embedded dynamic random-access memory (eDRAM) or spin transfer torque magnetic random-access memory (STT-M RAM).

Computing device 700 may include a heat regulation/refrigeration device 706. Heat regulation/refrigeration device 706 may maintain processing device 701 (and/or other components of computing device 700) at a predetermined low temperature during operation. This predetermined low temperature may be any temperature discussed elsewhere herein.

In some embodiments, computing device 700 may include a communication chip 707 (e.g., one or more communication chips). For example, the communication chip 707 may be configured for managing wireless communications for the transfer of data to and from computing device 700. The term "wireless" and its derivatives may be used to describe circuits, devices, systems, methods, techniques, communications channels, etc., that may communicate data through the use of modulated electromagnetic radiation through a nonsolid medium.

Communication chip 707 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). Communication chip 707 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 707 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 707 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 707 may operate in accordance with other wireless protocols in other embodiments. Computing device 700 may include an antenna 713 to facilitate wireless communications and/or to receive other wireless communications (such as AM or FM radio transmissions).

In some embodiments, communication chip 707 may manage wired communications, such as electrical, optical, or any other suitable communication protocols (e.g., the Ethernet). As noted above, communication chip 707 may include multiple communication chips. For instance, a first communication chip 707 may be dedicated to shorter-range wireless communications such as Wi-Fi or Bluetooth, and a second communication chip 707 may be dedicated to longer-range wireless communications such as GPS, EDGE, GPRS, CDMA, WiMAX, LTE, EV-DO, or others. In some embodiments, a first communication chip 707 may be dedicated to wireless communications, and a second communication chip 707 may be dedicated to wired communications.

Computing device 700 may include battery/power circuitry 708. Battery/power circuitry 708 may include one or more energy storage devices (e.g., batteries or capacitors) and/or circuitry for coupling components of computing device 700 to an energy source separate from computing device 700 (e.g., AC line power).

Computing device 700 may include a display device 703 (or corresponding interface circuitry, as discussed above). Display device 703 may include any visual indicators, such as a heads-up display, a computer monitor, a projector, a touchscreen display, a liquid crystal display (LCD), a light-emitting diode display, or a flat panel display, for example.

Computing device 700 may include an audio output device 704 (or corresponding interface circuitry, as discussed above). Audio output device 704 may include any device that generates an audible indicator, such as speakers, headsets, or earbuds, for example.

Computing device 700 may include an audio input device 710 (or corresponding interface circuitry, as discussed above). Audio input device 710 may include any device that generates a signal representative of a sound, such as microphones, microphone arrays, or digital instruments (e.g., instruments having a musical instrument digital interface (MIDI) output).

Computing device 700 may include a global positioning system (GPS) device 709 (or corresponding interface circuitry, as discussed above). GPS device 709 may be in communication with a satellite-based system and may receive a location of computing device 700, as known in the art.

Computing device 700 may include another output device 705 (or corresponding interface circuitry, as discussed above). Examples include an audio codec, a video codec, a printer, a wired or wireless transmitter for providing information to other devices, or an additional storage device.

Computing device 700 may include another input device 711 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 700 may include a security interface device 712. Security interface device 712 may include any device that provides security measures for computing device 700 such as intrusion detection, biometric validation, security encode or decode, managing access lists, malware detection, or spyware detection. In some examples, security interface device 712 comprises OTP ROM further including a via MIM fuse, for example as described elsewhere herein.

Computing device 700, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments described above, but can instead be practiced with modification and alteration without departing from the scope of the appended claims. For example, the above embodiments may include specific combinations of features as further provided below.

In first examples, an apparatus comprises a transistor structure comprising a gate electrode, a silicon source semiconductor material, and a silicon drain semiconductor material. The apparats comprises a first interconnect metallization structure over a frontside of the transistor structure. The apparatus comprises a backside dielectric material layer in contact with backside surfaces of the silicon source semiconductor material, the silicon drain semiconductor material, and the gate electrode. The backside surfaces of the silicon source and drain semiconductor materials are non-coplanar with the backside surface of the gate electrode. The apparatus comprises a second interconnect metallization structure over a backside surfaces of transistor structure.

In second examples, for any of the first examples the first interconnect metallization structure is electrically coupled to at least the gate electrode, and a second interconnect metallization structure extends through the backside dielectric material layer and is electrically coupled at least the silicon source semiconductor or the silicon drain semiconductor material.

In third examples, for any of the second examples a thickness of the backside dielectric material over the backside surfaces of the silicon source and drain semiconductor materials is less than the thickness of the backside dielectric material over the backside surface of the gate electrode.

In fourth examples, for any of the second through third examples the apparatus comprising a second transistor structure comprising a second gate electrode, a SiGe source semiconductor material, and a SiGe drain semiconductor material, and wherein a thickness of the backside dielectric material over backside surfaces of the SiGe source and drain semiconductor materials is less than the thickness of the backside dielectric material over the backside surface of the second gate electrode.

In fifth examples, for any of the fourth examples the thickness of the backside dielectric material over the backside surface of the SiGe source and drain semiconductor material differs by no more than 10 nm from the thickness of the backside dielectric material over the backside surface of the silicon source and drain semiconductor material.

In sixth examples, for any of the first through fifth examples the apparatus comprises an etch stop material layer in contact with the backside surfaces of the silicon source and drain semiconductor materials. The second interconnect metallization structure extends through the etch stop material layer.

In seventh examples, for any of the sixth examples the etch stop material layer is absent from a backside surface of a SiGe source and drain semiconductor material of an adjacent second transistor structure.

In eighth examples, for any of the sixth through seventh examples the etch stop material layer comprises Ge.

In ninth examples, for any of the sixth through eighth examples the etch stop material layer comprises a crystalline material.

In tenth examples, for any of the sixth through eighth examples the etch stop material layer comprises an amorphous dielectric material.

In eleventh examples, for any of the sixth through tenth examples the etch stop material has a layer thickness of no more than 10nm.

In twelfth examples, an integrated circuit (IC) structure comprises an NMOS transistor structure, comprising a first gate around a plurality of transistor channel layers in a first stack, an N-type source semiconductor material, and an N-type drain semiconductor material coupled to the channel layers in the first stack. The IC structure comprises a PMOS transistor structure, comprising a second gate around a plurality of transistor channel layers in a second stack, a P-type source semiconductor material, and a P-type drain semiconductor material coupled to the channel layers in the second stack. The IC structure comprises a first interconnect metallization structure over a first side of the NMOS and PMOS transistor structures. The IC structure comprises a second interconnect metallization structure over a second side of the NMOS and PMOS transistor structures. Surfaces of the N-type source and drain semiconductor materials are closer to the second metallization structure than is a backside surface of the first gate.

In thirteenth examples, for any of the twelfth examples backside surfaces of the P-type source and drain semiconductor materials are closer to the second metallization structure than is a backside surface of the second gate.

In fourteenth examples, for any of the thirteenth examples the backside surface of the P-type source and drain semiconductor materials are within 10nm of being co-planar with the backside surface of the N-type source and drain semiconductor materials.

In fifteenth examples, a method comprises receiving a workpiece comprising a channel material layer stack adjacent to a subfin semiconductor material, forming a barrier material layer on the subfin semiconductor material, forming a source and drain semiconductor material over a front side of the barrier material layer, and removing the subfin semiconductor material from a back side of the barrier material layer.

In sixteenth examples, for any of the fifteenth examples the subfin semiconductor material is silicon, forming the barrier material layer comprises depositing a material comprising Ge on the subfin semiconductor material, and forming the source and drain semiconductor material comprises depositing silicon on the barrier material layer.

In seventeenth examples, for any of the sixteenth examples the method comprises forming a mask material over the channel material layer stack prior to forming the barrier material layer on the subfin semiconductor material.

In eighteenth examples, for any of the seventeenth examples forming the mask material comprises depositing a dielectric material layer over the channel material layer and the subfin semiconductor material, and anisotropically etching the dielectric material layer.

In nineteenth examples, for any of the seventeeth examples the subfin semiconductor material is silicon, forming the barrier material layer comprises depositing a dielectric material on the subfin semiconductor material, and forming the source and drain semiconductor material comprises epitaxially growing silicon laterally over the barrier material layer.

In twentieth examples, for any of the nineteenth examples forming the barrier material layer comprises depositing a mask material over the barrier material layer and recess etching the mask material and removing the barrier material layer from the channel material stack.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should, therefore, be determined with reference to the appended claims, along with the full scope of equivalents to which such claims are entitled.

## Claims

1. An apparatus, comprising:
a transistor structure comprising a gate electrode, a silicon source semiconductor material, and a silicon drain semiconductor material;
a first interconnect metallization structure over a frontside of the transistor structure;
a backside dielectric material layer in contact with backside surfaces of the silicon source semiconductor material, the silicon drain semiconductor material, and the gate electrode, wherein the backside surfaces of the silicon source and drain semiconductor materials are non-coplanar with the backside surface of the gate electrode; and
a second interconnect metallization structure over a backside surfaces of transistor structure.

2. The apparatus of claim 1, wherein:
the first interconnect metallization structure is electrically coupled to at least the gate electrode; and
a second interconnect metallization structure extends through the backside dielectric material layer and is electrically coupled at least the silicon source semiconductor or the silicon drain semiconductor material.

3. The apparatus of claim 2, wherein a thickness of the backside dielectric material over the backside surfaces of the silicon source and drain semiconductor materials is less than the thickness of the backside dielectric material over the backside surface of the gate electrode.

4. The apparatus of claim 2 or 3, further comprising a second transistor structure comprising a second gate electrode, a SiGe source semiconductor material, and a SiGe drain semiconductor material, and wherein a thickness of the backside dielectric material over backside surfaces of the SiGe source and drain semiconductor materials is less than the thickness of the backside dielectric material over the backside surface of the second gate electrode.

5. The apparatus of claim 4, wherein the thickness of the backside dielectric material over the backside surface of the SiGe source and drain semiconductor material differs by no more than 10 nm from the thickness of the backside dielectric material over the backside surface of the silicon source and drain semiconductor material.

6. The apparatus of any one of claims 1-5, further comprising an etch stop material layer in contact with the backside surfaces of the silicon source and drain semiconductor materials, and wherein the second interconnect metallization structure extends through the etch stop material layer.

7. The apparatus of claim 6, wherein the etch stop material layer is absent from a backside surface of a SiGe source and drain semiconductor material of an adjacent second transistor structure.

8. The apparatus of claim 6 or 7, wherein the etch stop material layer comprises Ge.

9. The apparatus of claim 6, 7 or 8, wherein the etch stop material layer comprises a crystalline material.

10. The apparatus of claim 6, 7 or 8, wherein the etch stop material layer comprises an amorphous dielectric material.

11. The apparatus of claim 6, 7, 8, 9 or 10, wherein the etch stop material has a layer thickness of no more than 10nm.

12. A method comprising:
receiving a workpiece comprising a channel material layer stack adjacent to a subfin semiconductor material;
forming a barrier material layer on the subfin semiconductor material;
forming a source and drain semiconductor material over a front side of the barrier material layer; and
removing the subfin semiconductor material from a back side of the barrier material layer.

13. The method of claim 12, wherein:
the subfin semiconductor material is silicon;
forming the barrier material layer comprises depositing a material comprising Ge on the subfin semiconductor material; and
forming the source and drain semiconductor material comprises depositing silicon on the barrier material layer.

14. The method of claim 13, further comprising forming a mask material over the channel material layer stack prior to forming the barrier material layer on the subfin semiconductor material.

15. The method of claim 13 or 14, wherein:
the subfin semiconductor material is silicon;
forming the barrier material layer comprises depositing a dielectric material on the subfin semiconductor material;
forming the source and drain semiconductor material comprises epitaxially growing silicon laterally over the barrier material layer; and
forming the barrier material layer comprises:
depositing a mask material over the barrier material layer; and
recess etching the mask material and removing the barrier material layer from the channel material layer stack.
